# EUROPEAN PATENT APPLICATION

(11) **EP 4 654 476 A1**
(43) Date of publication of application: **26.11.2025**
(21) Application number: 24744639.6
(22) Date of filing: 16.01.2024
(51) Int. Cl.: H03H 9/19, H03H 9/215

(54) **TUNING-FORK-TYPE PIEZOELECTRIC VIBRATING PIECE, TUNING-FORK-TYPE PIEZOELECTRIC VIBRATING ELEMENT, AND TUNING-FORK-TYPE PIEZOELECTRIC OSCILLATOR**

(30) Priority: 17.01.2023 JP 2023004819
(71) Applicant: Daishinku Corporation, Kakogawa-shi, Hyogo 6758565 (JP)
(72) Inventor: FUJII, Tomo, Kakogawa-shi, Hyogo 675-0194 (JP)
(74) Representative: TBK
(86) International application number: PCT/JP2024/000905
(87) International publication number: WO 2024/154718

(57) **Abstract**

Provided is a tuning-fork-type piezoelectric vibrating piece with which the reproducibility of frequency measurement can be improved. A tuning-fork-type piezoelectric vibrating piece 10 includes a crystal vibration piece 20 having a base part 21, first and second vibrating arms 22 and 23, and an external joining part 24, a pair of first and second excitation electrodes 31 and 32 formed on the first and second vibrating arms 22 and 23, first and second extraction electrodes 33 and 34 extracted from the first and second excitation electrodes 31 and 32 to the base part 21 and the external joining part 24, and first and second conductive joining parts 41 and 42 provided on the first and second extraction electrodes 33 and 34, with the first and second conductive joining parts 41 and 42 being provided so as to be entirely located biasedly only in a first region of the external joining part 24 on the side on which the first vibrating arm 22 is provided with a virtual centerline L1 extending in the extension direction of the first and second vibrating arms 22 and 23 through the center between the first and second vibrating arms 22 and 23 as a reference line.

## Description

### Technical Field

The present invention relates to a tuning-fork-type piezoelectric vibrating piece having a pair of vibrating arms that vibrate, a tuning-fork-type piezoelectric vibrating element having the tuning-fork-type piezoelectric vibrating piece, and a tuning-fork-type piezoelectric oscillator.

### Background Art

There are tuning-fork-type piezoelectric vibrating pieces that include a base part, a pair of vibrating arms (first vibrating arm, second vibrating arm) extending in one direction from one end portion of the base part, and a crystal vibration piece having an external joining part provided at the other end of the base part. Such a tuning-fork-type piezoelectric vibrating piece is provided with a pair of a first excitation electrode and a second excitation electrode formed on the first vibrating arm and the second vibrating arm, a first extraction electrode extracted from the first excitation electrode to the base part and the external joining part, and a second extraction electrode extracted from the second excitation electrode to the base part and the external joining part. Furthermore, the tuning-fork-type piezoelectric vibrating piece is provided with a first metal bump that is used when electrically and mechanically joining the first extraction electrode to a first external electrode, and a second metal bump that is used when electrically and mechanically joining the second extraction electrode to a second external electrode.

In the above tuning-fork-type piezoelectric vibrating piece, the first metal bump and the second metal bump are disposed so as to be entirely located in a first region and a second region of the external joining part, where a line extending through the center between the first vibrating arm and the second vibrating arm in the extension direction of the first vibrating arm and the second vibrating arm is defined as a virtual centerline, a region of the external joining part on the side on which the first vibrating arm is located with the virtual centerline as a reference line is defined as the first region, and a region of the external joining part on the side on which the second vibrating arm is located with the virtual centerline as a reference line is defined as the second region (e.g., see PTL 1).

### Citation List

### Patent Literature

PTL 1: JP 2021-68955A

### Summary of Invention

### Technical Problem

Incidentally, the outer shape of a crystal vibration piece constituting a tuning-fork-type piezoelectric vibrating piece is generally formed using photolithography technology and a wet etching process. When the outer shape is processed by wet etching the crystal vibration piece, asymmetrical regions may be formed on the crystal vibration piece. In particular, when an anisotropic material such as crystal is wet etched, such asymmetrical shapes tend to appear more markedly, and the portion of the fork formed by the first and second vibrating arms and the base part (hereinafter,_also "fork part of tuning fork") becomes asymmetrical, adversely affecting the balancing of the first vibrating arm and the second vibrating arm. When a tuning-fork-type piezoelectric vibrating element having such a tuning-fork-type piezoelectric vibrating piece is vibrated, a vibration mode different from the main vibration appears, and, specifically, unwanted vibration (spurious vibration) appears at frequencies lower than the frequency of the main vibration, thereby degrading the reproducibility with which the frequency of the main vibration is measured.

In view of the above issues, an object of the present invention is to provide a tuning-fork-type piezoelectric vibrating piece that is able to suppress the effects of unwanted vibration and improve the reproducibility of frequency measurement, a tuning-fork-type piezoelectric vibrating element having the tuning-fork-type piezoelectric vibrating piece, and a tuning-fork-type piezoelectric oscillator.

### Solution to Problem

In order to achieve the above object, a tuning-fork-type piezoelectric vibrating piece according to the present invention is a tuning-fork-type piezoelectric vibrating piece including a base part, a first vibrating arm and a second vibrating arm that extend in one direction from one end portion of the base part, an external joining part provided at another end portion of the base part, a pair of a first excitation electrode and a second excitation electrode formed on the first vibrating arm and the second vibrating arm, a first extraction electrode extracted from the first excitation electrode to the base part and the external joining part, a second extraction electrode extracted from the second excitation electrode to the base part and the external joining part, a first conductive joining part that is used when electrically and mechanically joining the first extraction electrode to a first external electrode, and a second conductive joining part that is used when electrically and mechanically joining the second extraction electrode to a second external electrode, in which, when a line extending in an extension direction of the first vibrating arm and the second vibrating arm through a center between the first vibrating arm and the second vibrating arm in plan view is defined as a virtual centerline, a region of the external joining part on a side on which the first vibrating arm is located with the virtual centerline as a reference line is defined as a first region, and a region of the external joining part on a side on which the second vibrating arm is located with the virtual centerline as a reference line is defined as a second region, the first conductive joining part and the second conductive joining part are provided so as to be entirely located biasedly only in the first region.

According to this configuration, by providing the first conductive joining part and the second conductive joining part so as to be entirely located biasedly only in the first region of the external joining part, vibration modes (unwanted vibration, spurious vibration) that differ from the main vibration can be kept away from the main vibration or damped, thereby allowing for suppression of the effects of unwanted vibration on the main vibration, and for improvement in measurement reproduction of the frequency of the main vibration. Also, by providing the first conductive joining part and the second conductive joining part so as to be entirely located biasedly only in the first region of the external joining part, it is possible to position the first conductive joining part and the second conductive joining part away from the center of the base part (away from the virtual centerline), making the first conductive joining part and/or the second conductive joining part positioned away from the center of the base part (away from the virtual centerline) less susceptible to the effects of unwanted vibration. As a result, the reproducibility of frequency measurement can be improved by reducing the effects of vibration leakage and unwanted vibration that are transmitted to the base part and the external joining part due to excitation of the first vibrating arm and the second vibrating arm of the tuning-fork-type piezoelectric vibrating piece.

Also, a portion of a fork formed by the first and second vibrating arms and the base part may be asymmetrical in plan view.

In the case of this configuration, providing the first conductive joining part and the second conductive joining part to be entirely located biasedly only in the first region of the external joining part is particularly effective in reducing the effects of vibration leakage.

Also, in plan view, the first region may be larger in area than the second region.

According to this configuration, by making the second region on the side on which unwanted vibration is released smaller in area than the first region, out of the first region and the second region of the external joining part, the first conductive joining part and the second conductive joining part can be more reliably made less susceptible to the effects of unwanted vibration by eliminating residual unwanted vibration. Also, by making the first region on the side on which the entirety of the first conductive joining part and the entirety of the second conductive joining part are provided larger in area than the second region, out of the first region and the second region of the external joining part, it is possible to position the first conductive joining part and the second conductive joining part further away from the center of the base part (further away from the virtual centerline), and the first conductive joining part and/or the second conductive joining part positioned further away from the center of the base part (further away from the virtual centerline) can be made less susceptible to the effects of unwanted vibration. Also, by making the first region on the side on which the entirety of the first conductive joining part and the entirety of the second conductive joining part are provided larger in area than the second region, out of the first region and the second region of the external joining part, it becomes possible to enlarge the area of the first conductive joining part and the second conductive joining part, enabling holding and mounting to a member on which the first external electrode and the second external electrode are provided to be stabilized by the first conductive joining part and/or the second conductive joining part whose area has been increased. As a result, the effects of vibration leakage are further reduced and the reproducibility of frequency measurement can be further improved.

Also, the first conductive joining part and the second conductive joining part may each be formed with a metal bump.

According to this configuration, by forming the first conductive joining part and the second conductive joining part with metal bumps, conduction performance between the first extraction electrode and the first external electrode and between the second extraction electrode and the second external electrode can be further enhanced and the electrodes can be joined in a more secure state, thereby enabling the first conductive joining part and the second conductive joining part to be reduced in area, and enabling miniaturization of components such as the tuning-fork-type piezoelectric vibrating element that uses the tuning-fork-type piezoelectric vibrating piece to be achieved. Also, although metal bumps are more susceptible to the effects of vibration leakage due to not being able to absorb stress and vibration compared to a material such as a conductive resin adhesive, the metal bumps can be made less susceptible to the effects of unwanted vibration by being positioned away from the center of the base part (away from the virtual centerline). Moreover, the metal bumps can be securely and stably joined to the external electrodes compared to a material such as a conductive resin adhesive, even when biasedly provided in the first region of the external joining part and joined to the external electrodes (first external electrode and second external electrode).

Also, a constriction may be provided between the base part and the external joining part.

According to this configuration, unwanted vibration that is transmitted from the base part to the external joining part can be dampened.

Also, a width of the base part in a direction in which the first vibrating arm and the second vibrating arm are arranged in parallel to each other in plan view may decrease proceeding from the first and second vibrating arms side of the base part to the external joining part side of the base part.

According to this configuration, unwanted vibration that is transmitted from the base part to the external joining part can be dampened.

Also, when a line connecting two ends of the other end portion of the base part in plan view is defined as a virtual disposition line, the external joining part may be located entirely only in a region on a side on which the base part is not located in plan view with the virtual disposition line as a reference line.

According to this configuration, miniaturization of the tuning-fork-type piezoelectric vibrating piece can be realized.

Also, the base part may be provided with a through-hole or a recessed part, and the through-hole or the recessed part may be provided between the first vibrating arm and the conductive joining part that is closer to the virtual centerline, out of the first conductive joining part and the second conductive joining part, in plan view.

According to this configuration, unwanted vibration can be made less likely to be transmitted from the base part to the conductive joining part closer to the virtual centerline out of the first conductive joining part and the second conductive joining part, and the conductive joining parts can be made less susceptible to the effects of unwanted vibration.

Also, the base part, the first vibrating arm, the second vibrating arm, and the external joining part may be made of crystal, and a negative direction of an X-axis of the crystal may, in plan view, be a direction from the second vibrating arm toward the first vibrating arm in a direction in which the first vibrating arm and the second vibrating arm are arranged in parallel to each other.

According to this configuration, a gradient resulting from a difference in etching rates can be formed in the portion from the edge of the base part on the negative X-axis direction side to the edge of the external joining part, thereby increasing the strength of that portion and enabling the occurrence of failure of the tuning-fork-type piezoelectric vibrating piece to be suppressed.

Also, a tuning-fork-type piezoelectric vibrating element according to the present invention is a tuning-fork-type piezoelectric vibrating element in which the tuning-fork-type piezoelectric vibrating piece is mounted and housed inside a vessel and hermetically sealed.

According to this configuration, a tuning-fork-type piezoelectric vibrating element having a tuning-fork-type piezoelectric vibrating piece with excellent reproducibility of frequency measurement can be provided.

Also, a tuning-fork-type piezoelectric oscillator according to the present invention is a tuning-fork-type piezoelectric oscillator in which the tuning-fork-type piezoelectric vibrating piece and an integrated circuit element having a temperature compensation circuit are mounted and housed inside a vessel and hermetically sealed.

According to this configuration, a tuning-fork-type piezoelectric oscillator having a tuning-fork-type piezoelectric vibrating piece with excellent reproducibility of frequency measurement can be provided. In particular, a function of suppressing frequency variation by applying a compensation voltage that corresponds to the ambient temperature to the inherent frequency characteristics of the tuning-fork-type piezoelectric vibrating element to change the capacitance is added to the tuning-fork-type piezoelectric oscillator having a temperature compensation circuit, and frequency stability is enhanced. In contrast, when variation occurs in the frequency reproducibility of the tuning-fork-type piezoelectric vibrating piece, temperature compensation is further implemented by the temperature compensation circuit in response to that variation, and thus there is concern that the final frequency will vary even more. In the present invention, further variation due to the temperature compensation circuit is suppressed by improving frequency reproducibility in the tuning-fork-type piezoelectric vibrating piece, and frequency stability can be further enhanced.

### Advantageous Effects of Invention

According to the present invention, by providing the first conductive joining part and the second conductive joining part so as to be entirely located biasedly only in the first region of the external joining part, vibration modes (unwanted vibration, spurious vibration) that differ from the main vibration can be kept away from the main vibration or damped, thereby allowing for suppression of the effects of unwanted vibration on the main vibration, and for improvement in measurement reproduction of the frequency of the main vibration. Also, by providing the first conductive joining part and the second conductive joining part so as to be entirely located biasedly only in the first region of the external joining part, it is possible to position the first conductive joining part and the second conductive joining part away from the center of the base part (away from the virtual centerline), making the first conductive joining part and/or the second conductive joining part positioned away from the center of the base part (away from the virtual centerline) less susceptible to the effects of unwanted vibration. As a result, the effects of vibration leakage and unwanted vibration that are transmitted to the base part and the external joining part due to excitation of the first vibrating arm and the second vibrating arm of the tuning-fork-type piezoelectric vibrating piece can be reduced and the reproducibility of frequency measurement can be improved.

### Brief Description of Drawings

[Fig. 1]

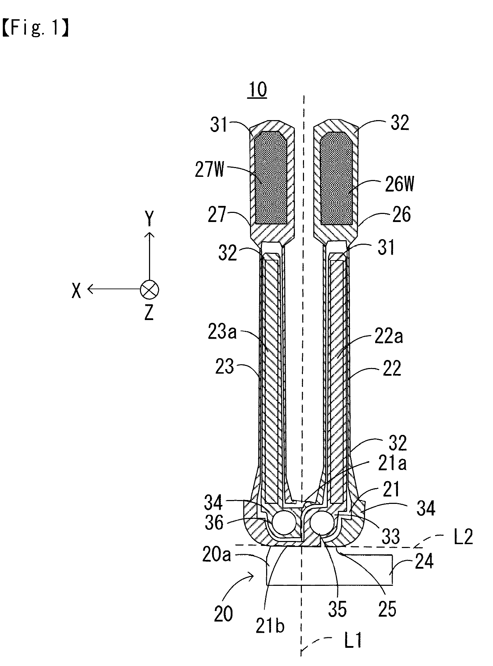

   Fig. 1 is a schematic plan view of one main surface side of a tuning-fork-type piezoelectric vibrating piece according to a first embodiment of the present invention.
[Fig. 2]

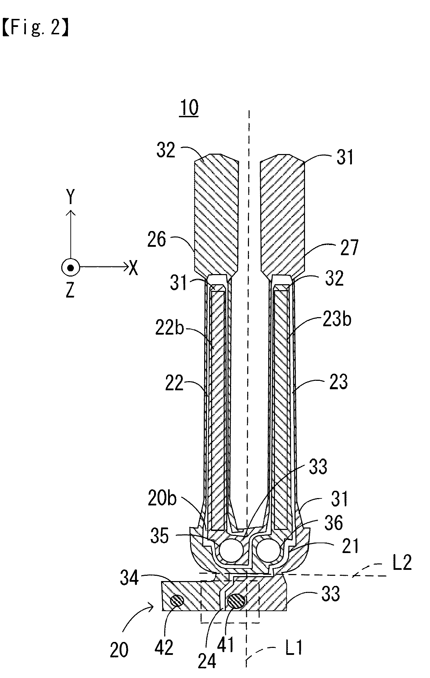

   Fig. 2 is a schematic plan view of the other main surface side of the tuning fork piezoelectric piece in Fig. 1.
[Fig. 3]

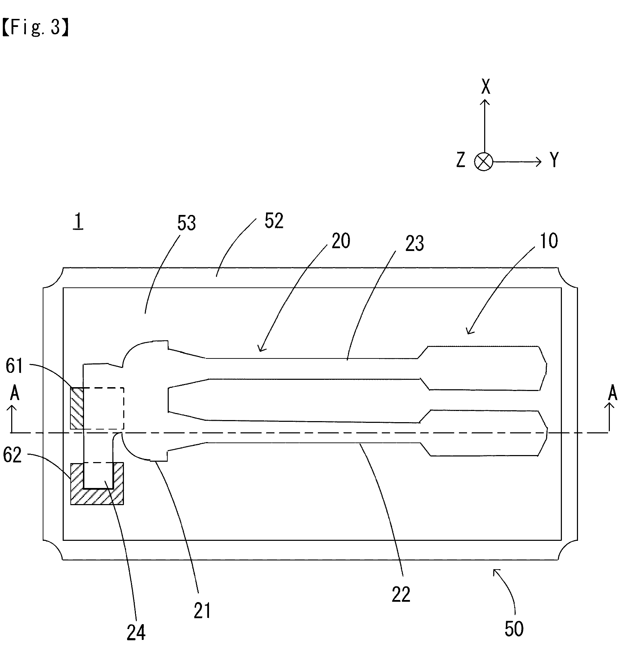

   Fig. 3 is a schematic plan view of an upper surface side of a tuning-fork-type piezoelectric vibrating element having the tuning fork piezoelectric piece of Figs. 1 and 2 before being hermetically sealed.
[Fig. 4]

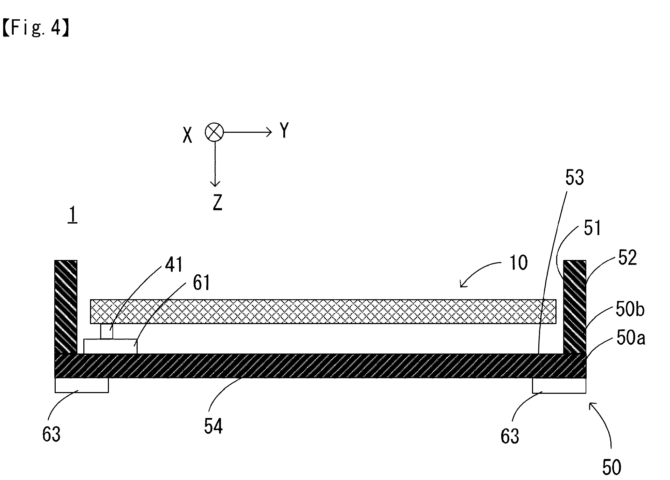

   Fig. 4 is a schematic side view of a cross-section taken along line A-A in Fig. 3 looking in the direction of the arrows.
[Fig. 5]

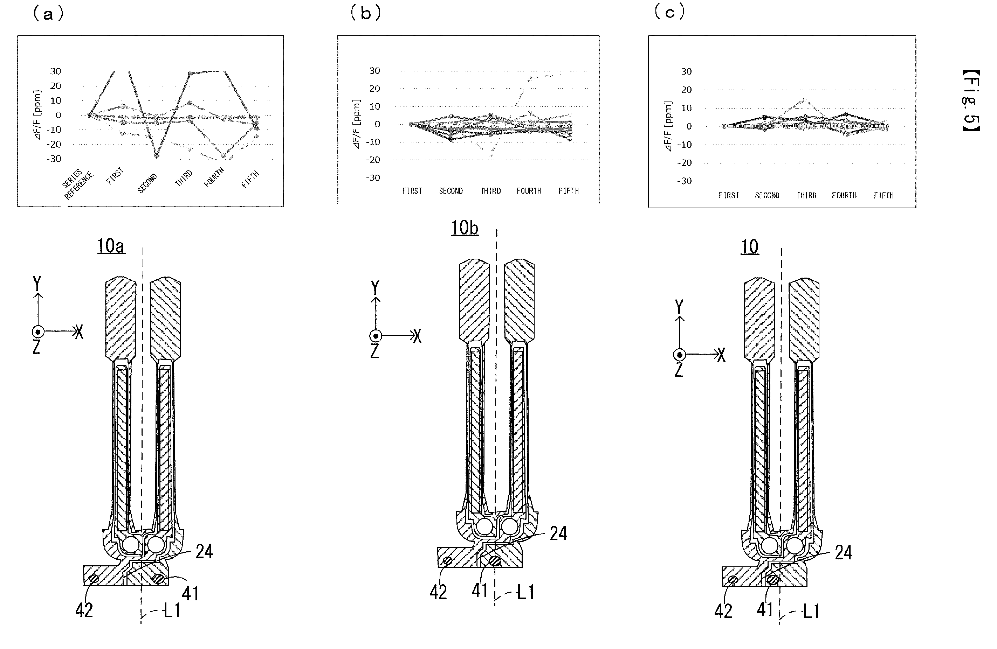

   Fig. 5 is a comparative diagram for comparing the reproducibility of frequency measurement for different disposition positions of a first conductive joining part and a second conductive joining part.
[Fig. 6]

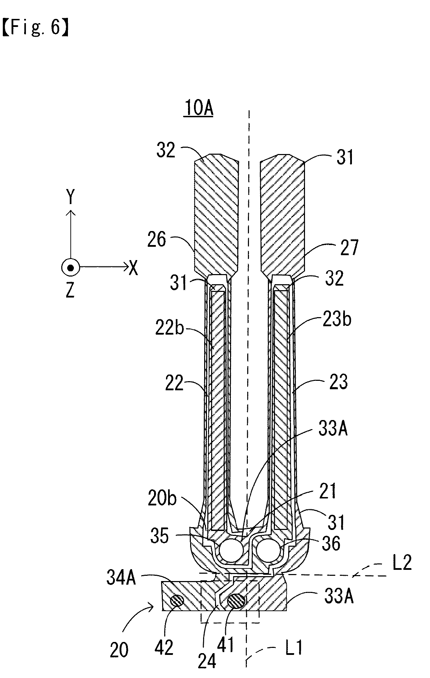

   Fig. 6 is a schematic plan view of the other main surface side of a tuning-fork-type piezoelectric vibrating piece according to a second embodiment of the present invention.
[Fig. 7]

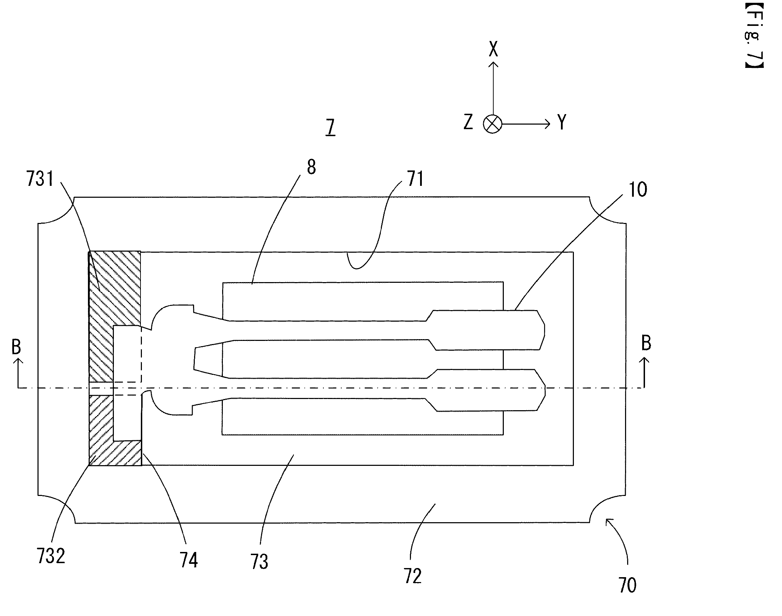

   Fig. 7 is a schematic plan view of an upper surface side of a tuning-fork-type piezoelectric oscillator having the tuning fork piezoelectric piece of Figs. 1 and 2 before being hermetically sealed according to a third embodiment of the present invention.
[Fig. 8]

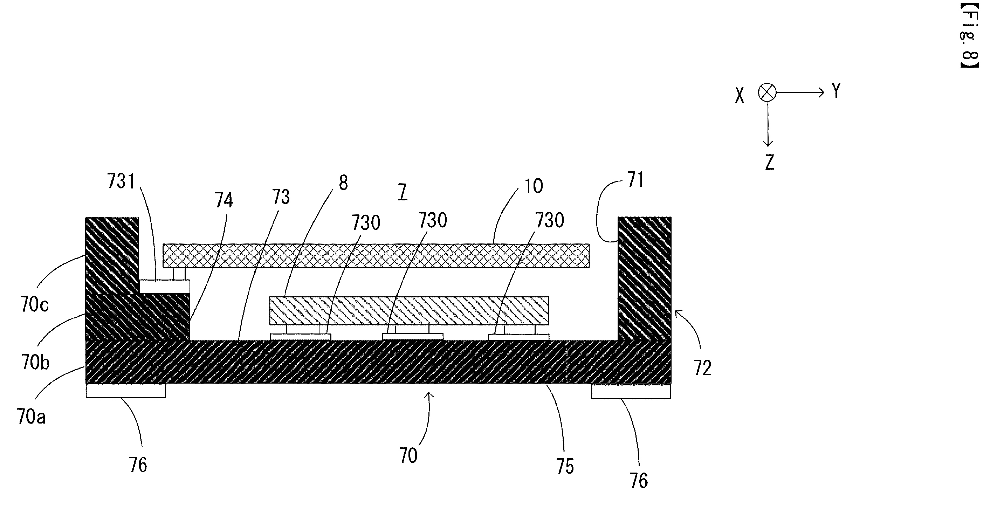

   Fig. 8 is a schematic side view of a cross-section taken along line B-B in Fig. 7 looking in the direction of the arrows.

### Description of Embodiments

### First Embodiment

Hereinafter, a tuning-fork-type piezoelectric vibrating piece 10 according to a first embodiment of the present invention and a tuning-fork-type piezoelectric vibrating element 1 having the tuning-fork-type piezoelectric vibrating piece 10 will be described in detail with reference to Figs. 1 to 5. Note that Figs. 1 to 4 and Fig. 6, which is used in later description, are illustrated utilizing the same X-axis, Y-axis, and Z-axis.

First, the configuration of the tuning-fork-type piezoelectric vibrating piece 10 will be described with reference to Figs 1 and 2. Fig. 1 is a schematic plan view of one main surface side of the tuning-fork-type piezoelectric vibrating piece 10, and Fig. 2 is a schematic plan view of the other main surface side of the tuning-fork-type piezoelectric vibrating piece 10.

The tuning-fork-type piezoelectric vibrating piece 10 is a piezoelectric vibration piece obtained by adding various electrodes (first excitation electrode 31, second excitation electrode 32, first extraction electrode 33, second extraction electrode 34), conductive joining parts (first conductive joining part 41, second conductive joining part 42) and the like to a tuning fork crystal vibration piece 20.

The tuning-fork-type piezoelectric vibrating piece 10 includes the above-described tuning fork crystal vibration piece 20, and, as shown in Figs. 1 and 2, the crystal vibration piece 20 includes a base part 21, a pair of vibrating arms (first vibrating arm 22, second vibrating arm 23) extending in one direction (in the present embodiment, positive Y-axis direction) from one end portion 21a of the base part 21, and an external joining part 24 provided at another end portion 21b of the base part 21.

A large number of crystal vibration pieces 20 are collectively formed at the same time from a single Z-cut synthetic quartz wafer. In the present embodiment, the outer shape of the crystal vibration piece 20 is formed using photolithography technology and wet etching. Note that, in Figs. 1 to 4 and Fig. 6 which is used in later description, the directions of the crystal vibration piece 20 are set such that the positive direction of the Y-axis of the crystal is the direction in which the first vibrating arm 22 and the second vibrating arm 23 extend from the base part 21 (extension direction), the negative direction of the X-axis of the crystal is the direction from the second vibrating arm 23 toward the first vibrating arm 22 in the width direction of the first vibrating arm 22 and the second vibrating arm 23 (direction in which the first vibrating arm 22 and the second vibrating arm 23 are arranged in parallel to each other), and the positive direction of the Z-axis of the crystal is the direction from one main surface 20a toward another main surface 20b of the crystal vibration piece 20 in the thickness direction of the first vibrating arm 22 and the second vibrating arm 23.

In the crystal vibration piece 20, a constriction 25 is provided between the base part 21 and the external joining part 24, in plan view of the one main surface 20a or the other main surface 20b of the crystal vibration piece 20 as viewed from the vertical direction (hereinafter, also simply "in plan view").

The width of the base part 21 in the direction in which the first vibrating arm 22 and the second vibrating arm 23 are arranged in parallel to each other in plan view (positive/negative X-axis direction) decreases proceeding from the one end portion 21a side of the base part 21 (first and second vibrating arms 22 and 23 side of base part 21) toward the other end portion 21b side of the base part 21 (external joining part 24 side of base part 21). Note that the base part 21 is not limited to this shape, and, for example, the width of the base part 21 in plan view may initially increase proceeding from the one end portion 21a side of the base part 21 (first and second vibrating arms 22 and 23 side of base part 21) toward the other end portion 21b side of the base part 21 (external joining part 24 side of base part 21) and decrease thereafter.

The shape of the external joining part 24 has a first extension part that extends from the other end portion 21b of the base part 21 on the opposite side (negative Y-axis direction side) to the direction in which the first vibrating arm 22 and the second vibrating arm 23 extend from the base part 21, and a second extension part that extends from the first extension part in the direction from the second vibrating arm 23 toward the first vibrating arm 22 (negative X-axis direction) in the direction in which the first vibrating arm 22 and the second vibrating arm 23 are arranged in parallel to each other, and is L-shaped in plan view.

A line extending in the extension direction of the first vibrating arm 22 and the second vibrating arm 23 through the center between the first vibrating arm 22 and the second vibrating arm 23 in the width direction (positive/negative X-axis direction) in plan view (center between first vibrating arm 22 and second vibrating arm 23 excluding the portion of the fork formed by first and second vibrating arms 22 and 23 and base part 21 (fork part of tuning fork)) is defined as a virtual centerline L1. In the region of the external joining part 24 in plan view, the region on the side on which the first vibrating arm 22 is located with the virtual centerline L1 as a reference line (region on the negative X-axis direction side with respect to the virtual centerline L1) is defined as a first region, and the region on the side on which the second vibrating arm 23 is located with the virtual centerline L1 as a reference line (region on the positive X-axis direction side with respect to the virtual centerline L1) is defined as a second region. A line connecting the two ends of the other end portion 21b of the base part 21 in plan view is defined as a virtual disposition line L2.

In plan view, the external joining part 24 is located only in the region on the side on which the base part 21 is not located with the virtual disposition line L2 as a reference line (region on the negative Y-axis direction side with respect to the virtual disposition line L2). In other words, in plan view, the external joining part 24 is not located in the region on the side on which the base part 21 is located with the virtual disposition line L2 as a reference line (region on the positive Y-axis direction side with respect to the virtual disposition line L2). Also, in plan view, the first region of the external joining part 24 is larger in area than the second region thereof.

In the crystal vibration piece 20 whose outer shape is formed by using photolithography technology and wet etching, the portion of the fork formed by the first and second vibrating arms 22 and 23 and the base part 21 (fork part of tuning fork) is, in plan view, asymmetrical with respect to the virtual centerline L1. In the present embodiment, the deepest portion of the fork part of the tuning fork is on the first vibrating arm 22 side with respect to the virtual centerline L1 (negative X-axis direction side with respect to the virtual centerline L1).

The first vibrating arm 22 has a first wide part 26 that is a part wider than the arm width of the first vibrating arm 22 (dimension in direction orthogonal to extension direction of first vibrating arm 22 (in the present embodiment, positive/negative X-axis direction)) on the distal end side thereof (far side from one end portion 21a of base part 21). Also, the second vibrating arm 23 has a second wide part 27 that is a part wider than the arm width of the second vibrating arm 23 (dimension in direction orthogonal to extension direction of second vibrating arm 23 (in the present embodiment, positive/negative X-axis direction)) on the distal end side thereof (far side from one end portion 21a of base part 21).

On the one main surface 20a side and the other main surface 20b of each of the first vibrating arm 22 and the second vibrating arm 23 constituting a pair, long grooves are formed for the purpose of further lowering an equivalent series resistance value (Crystal Impedance: hereinafter, also "CI value"). More specifically, on the one main surface 20a side and the other main surface 20b side of the first vibrating arm 22, a long groove 22a and a long groove 22b are formed at a predetermined depth so as to oppose each other (so as to overlap in plan view), and, on the one main surface 20a side and the other main surface 20b side of the second vibrating arm 23, a long groove 23a and a long groove 23b are formed at a predetermined depth so as to oppose each other (so as to overlap in plan view). The long grooves 22a and 22b are each formed such that, in plan view, one end side of the long groove extends to a region on the one end portion 21a side of the base part 21, and the other end side of the long groove is located on the base part 21 side with respect to the first wide part 26. Also, the long grooves 23a and 23b are each formed such that, in plan view, one end side of the long groove extends to a region on the one end portion 21a side of the base part 21, and the other end side of the long groove is located on the base part 21 side with respect to the second wide part 27. The long grooves 22a, 22b, 23a, and 23b have a longitudinal direction in the direction in which the first vibrating arm 22 and the second vibrating arm 23 extend (positive/negative Y-axis direction), and a width direction in the direction in which the first vibrating arm 22 and the second vibrating arm 23 are arranged in parallel to each other (positive/negative X-axis direction).

In the crystal vibration piece 20 are formed the pair of the first excitation electrode 31 and the second excitation electrode 32 formed on the first vibrating arm 22 and the second vibrating arm 23 constituted by different potentials, the first extraction electrode 33 extracted from the first excitation electrode 31 to the base part 21 and the external joining part 24, and the second extraction electrode 34 extracted from the second excitation electrode 32 to the base part 21 and the external joining part 24.

The first excitation electrode 31 is formed on the one main surface 20a side and the other main surface 20b side of the first vibrating arm 22, and on the side surface on the outer side and the side surface on the inner side of the second vibrating arm 23, via the one main surface 20a side and the other main surface 20b side of the wide part 27 of the second vibrating arm 23. Part of the first excitation electrode 31 that is formed on the one main surface 20a side and the other main surface 20b side of the first vibrating arm 22 is formed throughout the inside of the long grooves 22a and 22b of the first vibrating arm 22. The second excitation electrode 32 is formed on the one main surface 20a side and the other main surface 20b side of the second vibrating arm 23, and on the side surface on the outer side and the side surface on the inner side of the first vibrating arm 22, via the one main surface 20a side and the other main surface 20b side of the wide part 26 of the first vibrating arm 22. Part of the second excitation electrode 32 that is formed on the one main surface 20a side and the other main surface 20b side of the second vibrating arm 23 is formed throughout the inside of the long grooves 23a and 23b of the second vibrating arm 23. By forming the long grooves 22a, 22b, 23a, and 23b, the electric field efficiency between the pair of the first vibrating arm 22 and the second vibrating arm 23 is enhanced even if the tuning-fork-type piezoelectric vibrating piece 10 is miniaturized, and a favorable CI value can be obtained. Note that a configuration may be adopted in which part of the first excitation electrode 31 is formed only in a partial region of the long grooves 22a and 22b of the first vibrating arm 22, and part of the second excitation electrode 32 is formed only in a partial region of the long grooves 23a and 23b of the second vibrating arm 23.

The first extraction electrode 33 is formed on the one main surface 20a side and the other main surface 20b side of the base part 21 and the other main surface 20b side of the external joining part 24. The second extraction electrode 34 is formed on the one main surface 20a side and the other main surface 20b side of the base part 21 and the other main surface 20b side of the external joining part 24. In the region enclosed by the dashed line in Fig. 2 on the other main surface 20b side of the external joining part 24, a partition groove that partitions the first extraction electrode 33 and the second extraction electrode 34 is provided on the first vibrating arm 22 side with respect to the virtual centerline L1, and the first extraction electrode 33 and the second extraction electrode 34 are provided, such that the entirety of the first conductive joining part 41 is disposable in the portion of the first extraction electrode 33 between the virtual centerline L1 and the partition groove.

In the base part 21, a through-hole that passes through in the thickness direction (positive/negative Z-axis direction) is provided, a first through-hole electrode 35 obtained by depositing a conductive substance on the inner wall surface of the through-hole is formed, and the first through-hole electrode 35 electrically connects a portion of the first extraction electrode 33 formed on the one main surface 20a side of the base part 21 and a portion of the first extraction electrode 33 formed on the other main surface 20b side of the base part 21. Also, in the base part 21, a through-hole that passes through in the thickness direction (Z-axis direction) is provided, a second through-hole electrode 36 obtained by depositing a conductive substance on the inner wall surface of the through-hole is formed, and the second through-hole electrode 36 electrically connects a portion of the second extraction electrode 34 formed on the one main surface 20a side of the base part 21 and a portion of the second extraction electrode 34 formed on the other main surface 20b side of the base part 21. The through-hole in which the first through-hole electrode 35 is formed on the inner wall surface thereof is, in plan view, provided between the first vibrating arm 22 and the first conductive joining part 41 which is closer to the virtual centerline L1, out of the first conductive joining part 41 and the second conductive joining part 42.

Note that a configuration may be adopted in which a recessed part is, in plan view, provided between the first vibrating arm 22 and the first conductive joining part 41 which is closer to the virtual centerline L1, out of the first conductive joining part 41 and the second conductive joining part 42.

The first excitation electrode 31, the second excitation electrode 32, the first extraction electrode 33, and the second extraction electrode 34 described above each have a layer configuration in which a chromium (Cr) layer is formed on a quartz substrate, and a gold (Au) layer is laminated on the chromium layer. Note that the layer configuration of the electrodes 31 to 34 is not limited to a layer configuration in which a gold layer is laminated on a chromium layer, and may be another layer configuration, such as a layer configuration in which a gold (Au) layer is laminated on a Ti (titanium) layer. The electrodes 31 to 34 are collectively formed at the same time in a desired pattern by photolithography technology and metal etching after forming a film on the entirety of the main surfaces (one main surface 20a, other main surface 20b) of a quartz wafer by a film formation means such as a vacuum deposition method or sputtering.

A first frequency adjustment metal film (first frequency adjustment weight) 26W is formed on only the one main surface 20a side of the first wide part 26, and a second frequency adjustment metal film (second frequency adjustment weight) 27W is formed on only the one main surface 20a side of the second wide part 27. The frequency of the tuning-fork-type piezoelectric vibrating piece 10 is finely adjusted, by reducing the mass of the frequency adjustment metal films 26W and 27W through irradiation of a beam such as a laser beam or an ion beam. Note that the first frequency adjustment metal film 26W is, in plan view, formed slightly smaller in area than the portion of the second excitation electrode 32 formed on the one main surface 20a side of the first wide part 26, and the second frequency adjustment metal film 27W is, in plan view, formed slightly smaller in area than the portion of the first excitation electrode 31 formed on the one main surface 20a side of the second wide part 27.

The first conductive joining part 41 is provided on part of the portion of the first extraction electrode 33 formed on the other surface 20b side of the external joining part 24, and the second conductive joining part 42 is provided on part of the portion of the second extraction electrode 34 formed on the other surface 20b side of the external joining part 24. The first conductive joining part 41 and the second conductive joining part 42 are, in the present embodiment, formed with metal bumps such as gold bumps or gold-plated bumps. Note that the conductive joining parts 41 and 42 are not limited to metal bumps, and may be, for example, a conductive resin adhesive or the like.

In plan view, the first conductive joining part 41 and the second conductive joining part 42 are provided so as to be entirely located biasedly only in a first region of the external joining part 24 (region on the side on which first vibrating arm 22 is located with virtual centerline L1 as a reference line (region on negative X-axis direction side with respect to virtual centerline L1)). In plan view, the first conductive joining part 41 which is closer to the virtual centerline L1, out of the first conductive joining part 41 and the second conductive joining part 42, is provided in the vicinity of the virtual centerline L1.

In plan view, the first conductive joining part 41 which is closer to the virtual centerline L1, out of the first conductive joining part 41 and the second conductive joining part 42, is larger in area than the second conductive joining part 42 which is further away from the virtual centerline L1.

In plan view, the first conductive joining part 41 and the second conductive joining part 42 both have an elliptical shape, and the first conductive joining part 41 and the second conductive joining part 42 are provided such that, in plan view, the direction of the long axis of both the first conductive joining part 41 and the second conductive joining part 42 is the direction (positive/negative X-axis direction) in which the first conductive joining part 41 and the second conductive joining part 42 are arranged in parallel to each other.

Next, the tuning-fork-type piezoelectric vibrating element 1 including the tuning-fork-type piezoelectric vibrating piece 10 of Figs. 1 and 2 will be described with reference to Figs. 3 and 4. Fig. 3 is a schematic plan view of the upper surface side of the tuning-fork-type piezoelectric vibrating element 1 having the tuning-fork-type piezoelectric vibrating piece of Figs. 1 and 2 before being hermetically sealed, and Fig. 4 is a schematic cross-sectional view taken along line A-A in Fig. 3. Note that, in Figs. 1 and 2, the electrodes (first excitation electrode 31, second excitation electrode 32, first extraction electrode 33, second extraction electrode 34) provided on the tuning-fork-type piezoelectric vibrating piece 10 and the like are not illustrated.

The tuning-fork-type piezoelectric vibrating element 1 is constituted by, as main constituent members, a vessel 50 having an insulating material as a base material, the tuning-fork-type piezoelectric vibrating piece 10 described using Figs. 1 and 2, and a flat lid (not shown) that hermetically seals the tuning-fork-type piezoelectric vibrating piece 10 by being joined to the vessel 50. After being housed in a recessed part 51 of the vessel 50, the tuning-fork-type piezoelectric vibrating piece 10 is hermetically sealed by the lid being connected to the opening edge of the vessel 50 so as to cover the recessed part. The vessel 50 and the lid are joined via a sealing material (not shown). Here, the vessel 50 and the lid are joined via a sealing material (not shown).

The vessel 50 is a box body shape made of an insulating material having a ceramic such as alumina as a base material, and is, for example, formed by two ceramic green sheets 50a and 50b being laminated and integrally fired. The vessel 50 has the recessed part 51, which is rectangular in plan view, on the inner side of a bank part 52 that is frame shaped in plan view. On the upper surface of the bank part 52, a sealing material (not shown) is formed in a frame shape in plan view, with the sealing material corresponding to an outer peripheral portion of the lid.

On the short-side side of an inner bottom surface 53 of the recessed part 51, a first mounting pad (first external electrode) 61 and a second mounting pad (second external electrode) 62, which are mechanically and electrically joined to the first extraction electrode 33 and the second extraction electrode 34 of the tuning-fork-type piezoelectric vibrating piece 10 by the first conductive joining part 41 and the second conductive joining part 42, are disposed with a gap between each other. Also, an external connection terminal 63 is provided at each of the four corners of an outer bottom surface 54 of the vessel 50, with the first mounting pad 61 being connected to one external connection terminal 63, and the second mounting pad 62 being connected to another external connection terminal 63. The first mounting pad 61 and the second mounting pad 62 have different polarities from each other.

The first mounting pad 61 and the second mounting pad 62 are formed by laminating gold on the upper surface of a tungsten metallized layer using a technique such as plating. Note that, as the metallized layer, molybdenum, for example, may be used instead of tungsten. Note that a metal film the same as the mounting pad is also formed on the opening edge of the vessel 50 that is connected to the lid described later.

The first mounting pad 61 is electrically connected to one of the four external connection terminals 63 of the outer bottom surface 54 of the vessel 50, via internal wiring (not shown) and a side conductor (castellation conductor) (not shown) provided in a corner of the ceramic green sheet 50a which is the first layer of the vessel 50. The second mounting pad 62 is electrically connected to another of the four external connection terminals 63 of the outer bottom surface 54 of the vessel 50, via internal wiring (not shown) and a side conductor (castellation conductor) (not shown) provided in a corner of the ceramic green sheet 50a which is the first layer of the vessel 50.

The lid is a metal lid body that has Kovar as a base material and is rectangular in plan view, and a nickel-plated layer is formed on the outer and inner surfaces of the lid. Also, on the surface side of the lid that is joined to the vessel 50, a brazing material made of metal is formed over the entire surface of the nickel-plated layer. Note that an example of the brazing material is a gold-tin alloy layer. In this case, the nickel-plated layer is formed on the upper surface of the Kovar layer, a gold-plated layer is formed on an upper portion thereof, and a gold-tin alloy layer is formed on an upper portion thereof.

According to the tuning-fork-type piezoelectric vibrating piece 10 of the first embodiment described above, by providing the first conductive joining part 41 and the second conductive joining part 42 so as to be entirely located biasedly only in the first region of the external joining part 24, vibration modes (unwanted vibration, spurious vibration) that differ from the main vibration can be kept away from the main vibration or damped, thereby allowing for suppression of the effects of unwanted vibration on the main vibration, and for improvement in measurement reproduction of the frequency of the main vibration. Also, by providing the first conductive joining part 41 and the second conductive joining part 42 so as to be entirely located biasedly only in the first region of the external joining part 24, it is possible to position the first conductive joining part 41 and the second conductive joining part 42 away from the center of the base part (away from virtual centerline L1), making the first conductive joining part 41 and/or the second conductive joining part 42 (in the present embodiment, second conductive joining part 42) positioned away from the center of the base part 21 (away from virtual centerline L1) less susceptible to the effects of unwanted vibration. As a result, the reproducibility of frequency measurement can be improved by reducing the effects of vibration leakage and unwanted vibration that are transmitted to the base part 21 and the external joining part 24 due to excitation of the first vibrating arm 22 and the second vibrating arm 23 of the tuning-fork-type piezoelectric vibrating piece 10.

The tuning-fork-type piezoelectric vibrating piece 10 of the first embodiment described above is more suitable when applied to a tuning-fork-type piezoelectric oscillator in which the temperature compensation circuit of a TCXO, an RTC or the like is interposed. In general, a function of suppressing frequency variation by applying a compensation voltage that corresponds to the ambient temperature to the inherent frequency characteristics of the tuning-fork-type piezoelectric vibrating element to change the capacitance is added to the temperature compensation circuit, and frequency stability is enhanced. In contrast, when variation occurs in the frequency reproducibility of the tuning-fork-type piezoelectric vibrating piece 10, temperature compensation is further implemented by the temperature compensation circuit in response to that variation, and thus there is concern that the final frequency will vary even more. Further variation due to the temperature compensation circuit is suppressed by improving frequency reproducibility in the tuning-fork-type piezoelectric vibrating piece 10 of the first embodiment described above, and frequency stability can be enhanced.

Here, the disposition of the first conductive joining part 41 and the second conductive joining part 42 of the tuning-fork-type piezoelectric vibrating piece 10 of the first embodiment described above will be compared with the reproducibility of frequency measurement of different dispositions. Mounting tests were conducted with a plurality of each of tuning-fork-type piezoelectric vibrating pieces 10a, 10b, and 10 over five cycles, with Fig. 5(a) being directed toward the tuning-fork-type piezoelectric vibrating piece 10a in which the first conductive joining part 41 was entirely located in the second region and the second conductive joining part 42 was entirely located in the first region, Fig. 5(b) being directed toward the tuning-fork-type piezoelectric vibrating piece 10b in which the first conductive joining part 41 was located in the first region and the second region so as to straddle the virtual centerline L1, and the second conductive joining part 42 was entirely located in the first region, and Fig. 5(c) being directed toward the tuning-fork-type piezoelectric vibrating piece 10 (present embodiment) in which the first conductive joining part 41 and the second conductive joining part 42 were entirely located in the first region. The size of the tuning-fork-type piezoelectric vibrating pieces 10a, 10b, and 10 was L (positive/negative Y-axis direction) = 1.2 mm and W (positive/negative X-axis direction) = 0.4 mm, the external joining part 24 that is substantially L-shaped in plan view was provided below the base part 21, and the first conductive joining part 41 and the second conductive joining part 42 (gold-plated bumps) were formed on the extraction electrodes 33 and 34 of the external joining part 24. A base (vessel 50) housing the tuning-fork-type piezoelectric vibrating pieces 10a, 10b, and 10 was a 1.6 mm × 1.0 mm alumina ceramic base, and the first conductive joining part 41 and the second conductive joining part 42 (gold-plated bumps) of the tuning-fork-type piezoelectric vibrating pieces 10a, 10b, and 10 were mounted to mounting electrode pad parts on the bottom surface inside the base by ultrasonic joining. The size of the elliptical shape of the first conductive joining part 41 and the second conductive joining part 42 (gold-plated bumps) was 0.03 µm in length × 0.045 µm in width, and the distance between the first conductive joining part 41 and the second conductive joining part 42 was 0.17 µm in Fig. 5(a), 0.14 µm in Fig. 5(b), and 0.10 µm in Fig. 5(c). The hermetically sealed surface-mounted tuning fork vibrators were loaded in a frequency measurement jig and the frequency thereof was measured, with removal from the measurement jig and reloading being repeated five times, and the frequency at the time of each measurement being measured. Variation thereof was judged as the reproducibility of frequency measurement. It is evident from Figs. 5(a) to (c) that the tuning-fork-type piezoelectric vibrating piece 10 (present embodiment) in which the first conductive joining part 41 and the second conductive joining part 42 are located entirely in the first region has a higher reproducibility of frequency measurement than the other two tuning-fork-type piezoelectric vibrating pieces 10a and 10b.

In the case where the portion of the fork formed by the first and second vibrating arms 22 and 23 and the base part 21 (fork part of tuning fork) is asymmetrical, providing the first conductive joining part 41 and the second conductive joining part 42 to be entirely located biasedly only in the first region of the external joining part 24 is particularly effective in reducing the effects of vibration leakage.

Also, by making the second region on the side on which unwanted vibration is released smaller in area than the first region, out of the first region and the second region of the external joining part 24, the first conductive joining part 41 and the second conductive joining part 42 can be more reliably made less susceptible to the effects of unwanted vibration by eliminating residual unwanted vibration. Also, by making the first region on the side on which the entirety of the first conductive joining part and the entirety of the second conductive joining part are provided larger in area than the second region, out of the first region and the second region of the external joining part 24, it is possible to position the first conductive joining part 41 and the second conductive joining part 42 further away from the center of the base part 21 (further away from the virtual centerline L1), and the first conductive joining part 41 and/or the second conductive joining part 42 (in the present embodiment, second conductive joining part 42) positioned further away from the center of the base part 21 (further away from the virtual centerline L1) can be made less susceptible to the effects of unwanted vibration. Also, by making the first region on the side on which the entirety of the first conductive joining part 41 and the entirety of the second conductive joining part 42 are provided larger in area than the second region, out of the first region and the second region of the external joining part 24, it becomes possible to enlarge the area of the first conductive joining part 41 and the second conductive joining part 42, enabling holding and mounting to the member on which the first external electrode and the second external electrode which mechanically and electrically connect the first extraction electrode 33 and the second extraction electrode 34 are provided to be stabilized by the first conductive joining part 41 and/or the second conductive joining part 42 whose area has been increased. As a result, the effects of vibration leakage are further reduced and the reproducibility of frequency measurement can be further improved.

Also, by forming the first conductive joining part 41 and the second conductive joining part 42 with metal bumps, conduction performance between the first extraction electrode 33 and the first external electrode that mechanically and electrically joins the first extraction electrode 33 and between the second extraction electrode 34 and the second external electrode that mechanically and electrically joins the second extraction electrode 34 can be further enhanced and the electrodes can be joined in a more secure state, thereby enabling the first conductive joining part 41 and the second conductive joining part 42 to be reduced in area, and enabling miniaturization of components such as the tuning-fork-type piezoelectric vibrating element 1 that uses the tuning-fork-type piezoelectric vibrating piece 10 to be achieved. Also, although metal bumps are more susceptible to the effects of vibration leakage due to not being able to absorb stress and vibration compared to a material such as a conductive resin adhesive, the metal bumps can be made less susceptible to the effects of unwanted vibration by being positioned away from the center of the base part 21 (away from the virtual centerline L1). Moreover, the metal bumps can be securely and stably joined to the external electrodes compared to a material such as a conductive resin adhesive, even when biasedly provided in the first region of the external joining part 24 and joined to the external electrodes (first external electrode and second external electrode).

Also, unwanted vibration that is transmitted from the base part 21 to the external joining part 24 can be damped, by providing the constriction 25 between the base part 21 and the external joining part 24.

Also, unwanted vibration that is transmitted from the base part 21 to the external joining part 24 can be damped, by reducing the width of the base part 21 in the direction in which the first vibrating arm 22 and the second vibrating arm 23 are arranged in parallel to each other (positive/negative X-axis direction), proceeding from the one end portion 21a side of the base part 21 (first and second vibrating arms 22 and 23 side of base part 21) to the other end portion 21b side of the base part 21 (external joining part 24 side of base part 21).

Also, by providing the external joining part 24 so as to be located only in the region on the side on which the base part 21 is not located with the virtual disposition line L2 as a reference line, miniaturization of the tuning-fork-type piezoelectric vibrating piece 10 can be realized.

Also, by providing the through-hole in which the first through-hole electrode 35 is formed on the inner wall surface in the base part 21, between the first vibrating arm 22 and the first conductive joining part 41 which is closer to the virtual centerline L1, out of the first conductive joining part 41 and the second conductive joining part 42, unwanted vibration can be made less likely to be transmitted from the base part 21 to the first conductive joining part 41, and the first conductive joining part 41 can be made less susceptible to the effects of unwanted vibration. Note that similar effects can also be obtained if a recessed part is provided in the base part 21, between the first vibrating arm 22 and the first conductive joining part 41 which is closer to the virtual centerline L1, out of the first conductive joining part 41 and the second conductive joining part 42, instead of the through-hole in which the first through-hole electrode 35 is formed on the inner wall surface.

Also, by adopting a configuration in which the negative direction of the X-axis of the crystal of the crystal vibration piece 20 is the direction from the second vibrating arm 23 toward the first vibrating arm 22 in the direction in which the first vibrating arm 22 and the second vibrating arm 23 are arranged in parallel to each other, a gradient resulting from a different in etching rates can be formed in the portion from the edge of the base part 21 on the negative X-axis direction side to the edge of the external joining part 24, thereby increasing the strength of that portion and enabling the occurrence of failure of the tuning-fork-type piezoelectric vibrating piece 10 to be suppressed.

Also, by making the first conductive joining part 41 which is closer to the virtual centerline L1, out of the first conductive joining part 41 and the second conductive joining part 42, larger in area than the second conductive joining part 42 which is further away from the virtual centerline L1, tilting of the tuning-fork-type piezoelectric vibrating piece 10 due to the first conductive joining part 41 collapsing when mounting the tuning-fork-type piezoelectric vibrating piece 10 to the member on which the first external electrode and the second external electrode that mechanically and electrically join the first extraction electrode 33 and the second extraction electrode 34 are provided can be suppressed, and the tuning-fork-type piezoelectric vibrating piece 10 can be stably mounted to the member.

Also, by making the first conductive joining part 41 and the second conductive joining part 42 both elliptical in shape, and respectively providing the first conductive joining part 41 and the second conductive joining part 42 such that the direction of the long axis of the first conductive joining part 41 and the direction of the long axis of the second conductive joining part 42 correspond to the direction in which the first conductive joining part 41 and the second conductive joining part 42 are arranged in parallel to each other (positive/negative X-axis direction), tilting of the tuning-fork-type piezoelectric vibrating piece 10 when mounting the tuning-fork-type piezoelectric vibrating piece 10 to the member on which the first external electrode and the second external electrode that mechanically and electrically join the first extraction electrode 33 and the second extraction electrode 34 are provided can be suppressed, without unnecessarily enlarging the first conductive joining part 41 and the second conductive joining part 42, and the tuning-fork-type piezoelectric vibrating piece 10 can be stably mounted to the member.

Also, by making the external joining part 24 L-shaped in plan view, the first region of the external joining part 24 can be made larger in area than the second region in plan view, without making the first region and the second region of the external joining part 24 unnecessarily large in area, and miniaturization of the tuning-fork-type piezoelectric vibrating piece 10 having the external joining part 24 can be realized.

Also, by providing the first conductive joining part 41 which is closer to the virtual centerline L1, out of the first conductive joining part 41 and the second conductive joining part 42, in the vicinity of the virtual centerline L1, the tuning-fork-type piezoelectric vibrating piece 10 can be stably mounted to the member on which the first external electrode and the second external electrode that mechanically and electrically join the first extraction electrode 33 and the second extraction electrode 34 are provided, routing of the first external electrode that is mechanically and electrically joined to the first extraction electrode 33 on which the first conductive joining part 41 is provided can be reduced, and miniaturization of the member on which the first external electrode and the second external electrode that mechanically and electrically join the first extraction electrode 33 and the second extraction electrode 34 are provided can be realized.

Also, according to the tuning-fork-type piezoelectric vibrating element 1 of the first embodiment described above, the tuning-fork-type piezoelectric vibrating element 1 having the tuning-fork-type piezoelectric vibrating piece 10 that has the effects described above such as excellent reproducibility of frequency measurement can be provided.

### Second Embodiment

Hereinafter, a tuning-fork-type piezoelectric vibrating piece 10A according to a second embodiment of the present invention will be described in detail with reference to Fig. 6. Fig. 6 is a schematic plan view of the other main surface side of the tuning-fork-type piezoelectric vibrating piece 10A.

The first embodiment differs from the second embodiment in that the portion of the first extraction electrode 33 formed on the other main surface 20b side of the external joining part 24 and the portion of the second extraction electrode 34 formed on the other main surface 20b side of the external joining part 24 in the first embodiment differ in shape from the portion of a first extraction electrode 33A formed on the other main surface 20b side of the external joining part 24 and the portion of a second extraction electrode 34A formed on the other main surface 20b side of the external joining part 24 in the second embodiment. The remaining configuration is similar between the first embodiment and the second embodiment, and, in the second embodiment, the same reference numerals as the first embodiment will be given thereto and description thereof will be omitted.

The first extraction electrode 33A is formed on the one main surface 20a side and the other main surface 20b side of the base part 21 and the other main surface 20b side of the external joining part 24. The second extraction electrode 34A is formed on the one main surface 20a side and the other main surface 20b side of the base part 21 and on the other main surface 20b side of the external joining part 24. In the region enclosed by the dashed line in Fig. 6 on the other main surface 20b side of the external joining part 24, a partition groove partitioning the first extraction electrode 33A and the second extraction electrode 34A is provided on the first vibrating arm 22 side with respect to the virtual centerline L1, and the first extraction electrode 33A and the second extraction electrode 34A are provided such that the first conductive joining part 41 is entirely disposable in the portion of the first extraction electrode 33A between the virtual centerline L1 and the partition groove.

When the portion enclosed by the dashed line in Fig. 2 on the other main surface 20b side of the external joining part 24 of the first embodiment is compared with the portion enclosed by the dashed line in Fig. 6 on the other main surface 20b side of the external joining part 24 of the second embodiment, the first extraction electrode 33A, in plan view, is formed to extend to a position further away from the virtual centerline L1, in the direction from the second vibrating arm 23 toward the first vibrating arm 22 (negative X-axis direction), than the first extraction electrode 33. In the present embodiment, the first extraction electrode 33A protrudes on the second extraction electrode 34A side in plan view.

According to the tuning-fork-type piezoelectric vibrating piece 10A of the second embodiment described above, similar effects to the tuning-fork-type piezoelectric vibrating piece 10 of the first embodiment described above are achieved. Also, according to the tuning-fork-type piezoelectric vibrating piece 10A, jutting out of the first conductive joining part 41 from the first extraction electrode 33A can be ameliorated, and deviation in the mounting position can be suppressed as a result of the position of the wiring pattern of a package mounting part that is visible through the tuning-fork-type piezoelectric vibrating piece 10A becoming easier to see.

### Third Embodiment

Hereinafter, a tuning-fork-type piezoelectric vibrating piece 10 and a tuning-fork-type piezoelectric oscillator 7 having the tuning-fork-type piezoelectric vibrating piece 10 according to a third embodiment of the present invention will be described in detail with reference to Figs. 7 and 8. Note that the third embodiment references the same tuning-fork-type piezoelectric vibrating piece 10 as disclosed in the first embodiment. Also, in the third embodiment, portions that are similar to the first embodiment will be given the same reference numerals and some of the description thereof will be omitted, with only the differences being described.

The tuning-fork-type piezoelectric oscillator 7 is constituted by, as main constituent members, a vessel 70 having an insulating material as a base material, the tuning-fork-type piezoelectric vibrating piece 10 described using Figs. 1 and 2, an integrated circuit element 8 for a TCXO (Temperature Compensated Crystal Oscillator) having a temperature compensation circuit, an oscillator circuit, and the like, and a flat lid (not shown) that hermetically seals the tuning-fork-type piezoelectric vibrating piece 10 by being joined to the vessel 70. The tuning-fork-type piezoelectric vibrating piece 10 and the integrated circuit element 8 are housed in a recessed part 71 of the vessel 70 and then hermetically sealed by the lid being connected to the opening edge of the vessel 70 so as to cover the recessed part 71. Here, the vessel 70 and the lid are joined via a sealing material (not shown).

The vessel 70 is a box body shape made of an insulating material having a ceramic such as alumina as a base material, and is, for example, formed by three ceramic green sheets 70a, 70b, and 70c being laminated and integrally fired. The vessel 70 has the recessed part 71 which is rectangular in plan view on the inner side of a bank part 72 that is frame shaped in plan view. On the upper surface of the bank part 72, a sealing material (not shown) is formed in a frame shape in plan view, with the sealing material corresponding to the outer peripheral portion of the lid.

On an inner bottom surface 73 of the recessed part 71, a plurality of mounting pads 730 to which the integrated circuit element 8 is mechanically and electrically joined are disposed with a gap between each other. External terminal parts (not shown) of the integrated circuit element 8 and the mounting pads 730 are joined by a conductive joining material such as gold bumps.

An intermediate step part 74 is formed on an upper portion of the inner bottom surface 73 of the recessed part 71. On the upper surface of the intermediate step part 74, a first mounting pad (first external electrode) 731 and a second mounting pad (second external electrode) 732, which are mechanically and electrically joined to the first extraction electrode 33 and the second extraction electrode 34 of the tuning-fork-type piezoelectric vibrating piece 10 by the first conductive joining part 41 and the second conductive joining part 42, are disposed with a gap between each other. Also, an external connection terminal 76 is provided at each of the four corners of an outer bottom surface 75 of the vessel 70, and necessary connections are made to the mounting pads 730 connected to the integrated circuit element 8. These four external connection terminals 76 are constituted by, for example, a power source terminal, a ground terminal, and an output terminal.

The lid is a metal lid body that has Kovar as a base material and is rectangular in plan view, and a nickel-plated layer is formed on the outer and inner surfaces of the lid. Also, on the surface side of the lid that is joined to the vessel 70, a brazing material made of metal is formed over the entire surface of the nickel-plated layer. Note that a gold-tin alloy layer is, for example, formed as the brazing material. In this case, a nickel-plated layer is formed on the upper surface of the Kovar, a gold-plated layer is formed on the upper surface thereof, and a gold-tin alloy layer is formed on the upper surface thereof.

In the third embodiment described above, an integrated circuit element for a TCXO having a temperature compensation circuit, an oscillator circuit, and the like was described as an example of the integrated circuit element 8, but an integrated circuit element for an RTC (Real Time Clock) constituted by a circuit having a date and time calendar function in addition to a temperature compensation circuit and an oscillator circuit may also be used.

In this way, the tuning-fork-type piezoelectric vibrating piece 10 of the third embodiment described above is more suitable when applied to the tuning-fork-type piezoelectric oscillator 7 in which the temperature compensation circuit of a TCXO, an RTC or the like is interposed. In general, a function of suppressing frequency variation by applying a compensation voltage that corresponds to the ambient temperature to the inherent frequency characteristics of the tuning-fork-type piezoelectric vibrating element to change the capacitance is added to the temperature compensation circuit, and frequency stability is enhanced. In contrast, when variation occurs in the frequency reproducibility of the tuning-fork-type piezoelectric vibrating piece 10, temperature compensation is further implemented by the temperature compensation circuit in response to that variation, and thus there is concern that the final frequency will vary even more. Further variation due to the temperature compensation circuit is suppressed by improving frequency reproducibility in the tuning-fork-type piezoelectric vibrating piece 10 of the first embodiment described above, and frequency stability can be enhanced.

Note that the tuning fork piezoelectric piece, the tuning-fork-type piezoelectric vibrating element, and the tuning-fork-type piezoelectric oscillator are not limited to the tuning-fork-type piezoelectric vibrating pieces 10 and 10A, the tuning-fork-type piezoelectric vibrating element 1, and the tuning-fork-type piezoelectric oscillator 7 described above, and various changes can be made thereto.

For example, in the first and other embodiments described above, the first conductive joining part 41 which is closer to the virtual centerline L1, out of the first conductive joining part 41 and the second conductive joining part 42, is, in plan view, larger in area than the second conductive joining part 42 which is further away from the virtual centerline L1, but the present invention is not limited thereto, and, for example, the first conductive joining part 41 which is closer to the virtual centerline L1, out of the first conductive joining part 41 and the second conductive joining part 42 may, in plan view, be smaller in area than the second conductive joining part 42 which is further away from the virtual centerline L1. By adopting such a configuration, the first conductive joining part 41 can be made less susceptible to the effects of unwanted vibration.

Also, in the third embodiment, a package structure (ceramic package) of an insulating material having a ceramic as a base material is used as the vessel, but the present invention is not limited thereto, and a package structure of an insulating material coated with a molded resin (molded package) may be used. In view of this, the schematic structure of a molded package will be described below. In a molded package, a glass epoxy substrate or the like is used as a flat base substrate for mounting components. On the upper surface side of this glass epoxy substrate, necessary wiring for electrically connecting to components is provided, and on the bottom surface side, necessary external terminals for leading the wiring to an external circuit board are formed. The chip-type tuning-fork-type piezoelectric vibrating element disclosed in the above embodiments is mounted by being electrically and mechanically joined to the wiring on part of the upper part of the glass epoxy substrate with a conductive joining material such as solder. An IC chip is mounted in a position in parallel to the tuning-fork-type piezoelectric vibrating element by being mechanically joined with a resin adhesive and necessary electrical connections are made by bonding a metal wire made of gold or the like to part of the wiring. On an upper part of the glass epoxy substrate on which the tuning-fork-type piezoelectric vibrating element and the IC chip are mounted is formed a molded resin covering the components.

Also, the contents of the above embodiments and the contents of the variations may be combined as appropriate.

### Industrial Applicability

The present invention can be widely applied to a tuning-fork-type piezoelectric vibrating piece having a pair of vibrating arms that vibrate, a tuning-fork-type piezoelectric vibrating element having the tuning-fork-type piezoelectric vibrating piece, and a tuning-fork-type piezoelectric oscillator.

### Reference Signs List

- 1: Tuning-fork-type piezoelectric vibrating element
- 10, 10A: Tuning-fork-type piezoelectric vibrating piece
- 20: Crystal vibration piece
- 21: Base part
- 22: First vibrating arm
- 23: Second vibrating arm
- 24: External joining part
- 25: Constriction
- 31: First excitation electrode
- 32: Second excitation electrode
- 33, 33A: First extraction electrode
- 34, 34A: Second extraction electrode
- 35: First through-hole electrode
- 36: Second through-hole electrode
- 41: First conductive joining part
- 42: Second conductive joining part
- L1: Virtual centerline
- L2: Virtual disposition line

## Claims

1. A tuning-fork-type piezoelectric vibrating piece comprising:
a base part;
a first vibrating arm and a second vibrating arm that extend in one direction from one end portion of the base part;
an external joining part provided at another end portion of the base part;
a pair of a first excitation electrode and a second excitation electrode formed on the first vibrating arm and the second vibrating arm;
a first extraction electrode extracted from the first excitation electrode to the base part and the external joining part;
a second extraction electrode extracted from the second excitation electrode to the base part and the external joining part;
a first conductive joining part that is used when electrically and mechanically joining the first extraction electrode to a first external electrode; and
a second conductive joining part that is used when electrically and mechanically joining the second extraction electrode to a second external electrode,
wherein, when a line extending in an extension direction of the first vibrating arm and the second vibrating arm through a center between the first vibrating arm and the second vibrating arm in plan view is defined as a virtual centerline, and
a region of the external joining part on a side on which the first vibrating arm is located with the virtual centerline as a reference line is defined as a first region, and a region of the external joining part on a side on which the second vibrating arm is located with the virtual centerline as a reference line is defined as a second region,
the first conductive joining part and the second conductive joining part are provided so as to be entirely located biasedly only in the first region.

2. The tuning-fork-type piezoelectric vibrating piece according to claim 1
wherein a portion of a fork formed by the first and second vibrating arms and the base part is asymmetrical in plan view.

3. The tuning-fork-type piezoelectric vibrating piece according to claim 1 or 2,
wherein, in plan view, the first region is larger in area than the second region.

4. The tuning-fork-type piezoelectric vibrating piece according to claim 1 or 2,
wherein the first conductive joining part and the second conductive joining part are each formed with a metal bump.

5. The tuning-fork-type piezoelectric vibrating piece according to claim 1 or 2,
wherein a constriction is provided between the base part and the external joining part.

6. The tuning-fork-type piezoelectric vibrating piece according to claim 1 or 2,
wherein a width of the base part in a direction in which the first vibrating arm and the second vibrating arm are arranged in parallel to each other in plan view decreases proceeding from the first and second vibrating arms side of the base part to the external joining part side of the base part.

7. The tuning-fork-type piezoelectric vibrating piece according to claim 1 or 2,
wherein when a line connecting two ends of the other end portion of the base part in plan view is defined as a virtual disposition line,
the external joining part is located entirely only in a region on a side on which the base part is not located in plan view with the virtual disposition line as a reference line.

8. The tuning-fork-type piezoelectric vibrating piece according to claim 1 or 2,
wherein the base part is provided with a through-hole or a recessed part, and
the through-hole or the recessed part is provided between the first vibrating arm and the conductive joining part that is closer to the virtual centerline, out of the first conductive joining part and the second conductive joining part, in plan view.

9. The tuning-fork-type piezoelectric vibrating piece according to claim 1 or 2,
wherein the base part, the first vibrating arm, the second vibrating arm, and the external joining part are made of crystal, and
a negative direction of an X-axis of the crystal is, in plan view, a direction from the second vibrating arm toward the first vibrating arm in a direction in which the first vibrating arm and the second vibrating arm are arranged in parallel to each other.

10. A tuning-fork-type piezoelectric vibrating element in which the tuning-fork-type piezoelectric vibrating piece according to claim 1 or 2 is mounted and housed inside a vessel and hermetically sealed.

11. A tuning-fork-type piezoelectric oscillator in which the tuning-fork-type piezoelectric vibrating piece according to claim 1 or 2 and an integrated circuit element having a temperature compensation circuit are mounted and housed inside a vessel and hermetically sealed.
